# EUROPEAN PATENT APPLICATION

(11) **EP 4 371 683 A1**
(43) Date of publication of application: **22.05.2024**
(21) Application number: 22841758.0
(22) Date of filing: 19.04.2022
(51) Int. Cl.: B23B 27/14, B23P 15/28, C23C 14/06

(54) **CUTTING TOOL**

(30) Priority: 12.07.2021 JP 2021114878
(71) Applicant: Kanefusa Kabushiki Kaisha, Ohguchi-cho, Niwa-gun Aichi 480-0192 (JP)
(72) Inventor: OGAWA, Takashi, Niwa-gun, Aichi 480-0192 (JP); YAMADA, Yasunari, Niwa-gun, Aichi 480-0192 (JP)
(74) Representative: Maikowski & Ninnemann Patentanwälte Partnerschaft mbB
(86) International application number: PCT/JP2022/018201
(87) International publication number: WO 2023/286411

(57) **Abstract**

A replaceable blade (1) is used for cutting a workpiece made of nonferrous metals, nonferrous metal alloys, wood, woody materials, or resin. A coating (14) is provided to cover a base material (10). The coating (14) is provided on a flank (3) of a cutting edge (5) at an intersection of a rake face (4) and the flank (3), and the coating (14) has a columnar structure rising from the base material (10). The base material making the coating (14) includes one or more of chromium nitride, oxynitride, oxide, carbide, carboxide, carbonitride, and carboxynitride.

## Description

### Technical Field

One aspect of the present disclosure relates to cutting tools with surface coating. Cutting tools with surface coating may be used, for example, for cutting nonferrous metals, their alloys, wood, woody materials or resins.

### Background Technology

Cutting tools may be, for example, wood cutters and router bits used for cutting wood and wood-based composite materials. The cutting tool is provided with a blade body made of a base material such as steel, such as tool steel or bearing steel, or cemented carbide, for example. The rake face or flank of the blade may be coated with a hard, wear-resistant, corrosion-resistant coating to improve cutting sharpness and to sustain and increase cutting life. The coating may be made of chromium nitride, such as CrN, and may be coated on the base material, for example, by a PVD treatment method.

Hard coatings made of chromium nitride can provide wear resistance and other properties that cannot be achieved with a base material such as tool steel alone. However, when cutting wood with high moisture content, for example, the chromium component easily leaches out. Therefore, the surface coating may be eroded and the expected durability may not be obtained. Therefore, a cutting tool that is coated with a main coating made of chromium oxide or chromium oxynitride, for example, on top of a hard base coating made of chromium nitride has been proposed in the past.

Japanese Patent No. 5576788 describes a multilayer coating structure. The multilayer structure includes a hard basic coating layer coated on a rake face or flank and a hard main coating layer coated on the hard basic coating layer. The hard basic coating layer is made of chromium nitride, such as CrN. The hard main coating layer is composed of a material with higher corrosion resistance than the hard basic coating layer, such as chromium oxide (Cr₂O₃) or chromium oxynitride (CrNO). Japanese Patent No. 6002784 describes a coating in which the oxygen concentration of the hard main coating layer is varied in the thickness direction. This coating increases the toughness and heat resistance of the hard main coating layer.

When cutting workpiece with a cutting tool, the following problems may occur at the cutting edge. For example, the coating wears away. Chipping occurs, in which the coating is finely chipped by impact or vibration. The coating near the cutting edge on the rake face or flank tapers cracks. When the cutting edge is damaged by wear, chipping or coating cracking, it makes the cutting edge difficult to remain sharp. Chipping and coating cracking for example, expand from the base material to the surface layer of the coating that covers the flank or rake face. Chipping may progress to the area close to the cutting edge. Alternatively, coating cracking may occur across the rake face or flank. In such cases, the cutting edge is damaged and the effects of wear and corrosion resistance of the coating cannot be fully obtained. In the conventionally known coating structure, there was room for various improvements in order to sufficiently suppress damage to the cutting edge.

### Summary of Invention

### Technical Problem

Therefore, a configuration that prolong the sharpness of the cutting edge for cutting tools is desired. For example, suppressing damage to the coating in the area adjacent to the cutting edge can keep the cutting tool sharp.

### Solution to Problem

According to one aspect of the present disclosure, a cutting tool is used for cutting workpieces made of nonferrous metals, their alloys, wood, woody materials or resins. A coating is provided to cover a base material. The coating is provided on a flank of a cutting edge where a rake face intersects with a flank, and has a columnar structure rising from the base material. Materials making the coating includes one or more of chromium nitride, oxynitride, oxide, carbide, carboxide, carbonitride and carboxynitride.

By coating the flank with chromium-contained flank materials, cutting tool life is extendable. When chipping or coating cracking occurs in the coating covering the flank from the base material, the direction of progression can be controlled in the rising direction of the columnar structure. This prevents chipping and cracking from expanding over a wide area of the coating on the flank, and the thickness of the coating on the flank does not tend to become thin. This maintains the sharpness of the cutting edge.

According to another aspect of the present disclosure, a second coating is provided to cover the coating. The second coating includes one or more of chromium nitride, oxynitride, oxide, carbide, carboxide, carbonitride, and carboxynitride. Thus, for example, by providing the second coating with a material that has higher wear and corrosion resistance than the coating, wear, corrosion, etc., can be suppressed. While the coating on the base material side controls chipping and coating cracking on the flank, the second coating on the outer side controls wear and corrosion on the flank. This further suppresses damage to the cutting edges adjacent to the flank.

Another aspect of the present disclosure relates to a method of manufacturing cutting tools for cutting workpieces made of nonferrous metals, their alloys, wood, woody materials or resins. A coating is formed on the base material to include a columnar structure rising on a surface of the base material. The coating material includes one or more of chromium nitride, oxynitride, oxide, carbide, carboxide, carbonitride and carboxynitride. The coating is formed over the rake face and the flank. Some or entire coating on the rake face are removed to obtain sharp cutting edge where the rake face and the flank intersect.

Therefore, the durability of the flank and rake faces can be increased by the coating provided on the flank and rake faces and contains chromium material. Furthermore, when chipping or coating cracking expands through the coating, the expanding direction can be restricted to the rising direction of the columnar structure. This prevents chipping and coating cracking from expanding to the flank or rake face. Furthermore, when sharpening the cutting edge, some or entire coating covering the rake face is removed. This keeps the cutting edge sharp without removing the coating on the flank. Therefore, the flank is a coating with a columnar structure even after the cutting edge is sharpened. Damage to the cutting edges adjacent to the flank in the direction of chipping or coating cracking can be suppressed; therefore, prolonging the sharpness of the cutting edge.

### Brief Description of Drawings

FIG. 1 is a perspective view of a cutting tool according to a first embodiment.
FIG. 2 is a schematic cross-sectional view of a cutting edge of a blade.
FIG. 3 is a table showing various conditions of coatings on test pieces and comparative products.
FIG. 4 is an electron microscopic photograph of a cross-section of a flank of a test piece 20.
FIG. 5 is an electron microscopic photograph of a cross-section of a flank of a comparative product 30.
FIG. 6 is an electron microscopic photograph of a cross-section of a flank of a comparative product 40.
FIG. 7is an electron microscope photograph of a cutting edge of the test piece 20 after cutting.
FIG. 8 is an electron microscope photograph of a cutting edge of the comparative product 30 after cutting.
FIG. 9 is an electron microscope photograph of a cutting edge of the comparative product 40 after cutting.
FIG. 10 is a cross-sectional view of the cutting edge of the test piece 20 before and after cutting.
FIG. 11 is a cross-sectional view of the cutting edge of the comparative product 30 before and after cutting.
FIG. 12 is a cross-sectional view of the cutting edge of the comparative product 40 before and after cutting.
FIG. 13 is a side view of a cutting tool according to a second embodiment.
FIG. 14 is a schematic cross-sectional view of a cutting edge of a blade.
FIG. 15 is a table showing various conditions of coatings on the test pieces and comparative products.
FIG. 16 is an electron microscopic photograph of a cross-section of a flank of a test piece 70.
FIG. 17 is an electron microscopic photograph of a cross-section of a flank of a test piece 80.
FIG. 18 is an electron microscopic photograph of a cross-section of a flank of a comparative product 90.
FIG. 19 is an electron microscopic photograph of a cross-section of a flank of a comparative product 100.
FIG. 20 is an electron microscope photograph of the cutting edge of the test piece 70 after cutting 150m.
FIG. 21 is an electron microscope photograph of the cutting edge of the test piece 70 after cutting 400m.
FIG. 22 is an electron microscope photograph of the cutting edge of the test piece 80 after cutting.
FIG. 23 is an electron microscope photograph of the cutting edge of the comparative product 90 after cutting.
FIG. 24 is an electron microscope photograph of the cutting edge of the comparative product 100 after cutting.
FIG. 25 is a cross-sectional view of the cutting edge of the test piece 70 before and after cutting 150m.
FIG. 26 is a cross-sectional view of the cutting edge of the test piece 70 before and after cutting 400m.
FIG. 27 is a cross-sectional view of the cutting edge of the test piece 80 before and after cutting.
FIG. 28 is a cross-sectional view of the cutting edge of the comparative product 90 before and after cutting.
FIG. 29 is a cross-sectional view of the cutting edge of the comparative product 100 before and after cutting.

### Embodiments for carrying out the Invention

A cutting tool according to the present disclosure is used for cutting workpiece. The workpiece may be made of, for example, nonferrous metals such as aluminum and copper and their alloys, wood, woody materials, or resins. The technology of the present disclosure may be applicable, for example, to cutting tools such as flat blades such as planer blades, cutters, tipped saw blade, router bits, knives, and hollow chisels. Or it can be applied to replaceable blades for these cutting tools.

A blade provided in a cutting tool has a base material and a coating that covers the base material. The base material is made of steel such as tool steel, bearing steel, stainless steel, or cemented carbide. The coating covers at least a flank of the base material. A rake face of the base material may or may not be covered by the coating. In other words, the coating may be formed to cover the flank or both the flank and the rake face.

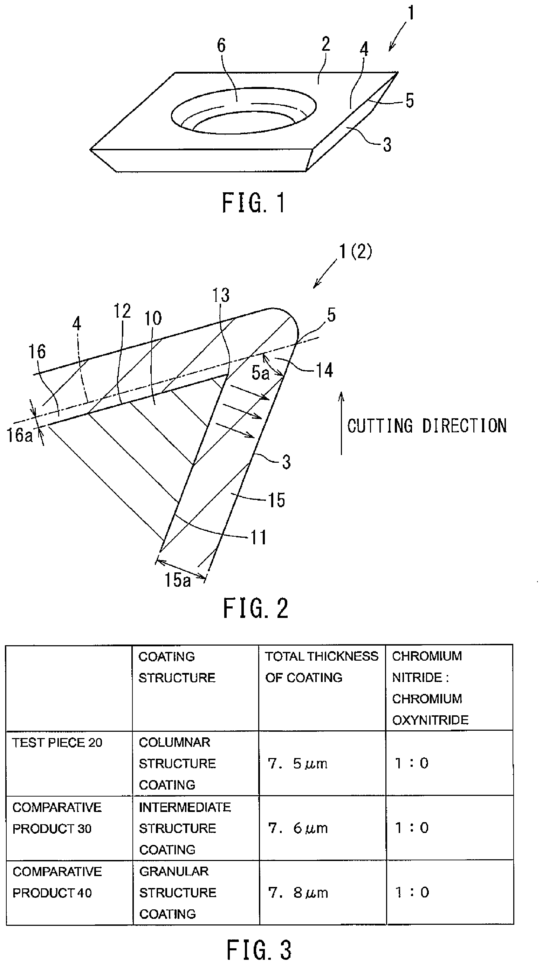

The cutting tool according to the first embodiment of the present disclosure will be described with reference to the drawings. As shown in FIGS. 1 and 2, a cutting tool of a first embodiment is a replaceable blade 1. The replaceable blade 1 may be attached to, for example, a blade replaceable milling cutter for woodworking or a blade replaceable router bit. The replaceable blade 1 has a rectangular plate-shaped blade 2. The blade 2 is provided with a through hole 6 that penetrates in a direction of the plate thickness. The blade 2 is attached to a tool body by fitting a blade mounting portion of the tool body into the through hole 6 and fastening with screws. The blade 2 has a flat finished flank 3 and a rake face 4. The flank 3 and the rake face 4 intersect at a cutting edge angle 5a to form a straight cutting edge 5 at the intersection. The cutting edge angle 5a is an acute angle, e.g., 50° to 60°. With the cutting edge 5 cutting into a workpiece at a predetermined cutting depth, the replaceable blade 1 is moved relative to the workpiece in a cutting direction as shown in the figure. This causes the cutting edge 5 to cut the workpiece at the predetermined cutting depth.

As shown in FIG. 2, a coating 14 covering the base material 10 is formed on the flank 3 and the rake face 4. The coating 14 has a flank coating 15 covering the base material flank 11 and a rake face coating 16 covering the base material rake face 12.

The coating 14 shown in FIG. 2 includes one or more of chromium nitride, oxynitride, oxide, carbide, carboxide, carbonitride, and carboxynitride. The coating 14 may include, for example, chromium nitride (CrN), chromium oxynitride (CrNO), chromium oxide (CrO), chromium carbide (CrC), chromium carboxide (CrCO), chromium carbonitride (CrCN), and chromium carboxynitride (CrCNO). The coating 14 is a single layer structure comprising one or more chromium materials.

As shown in FIG. 2, the flank coating 15 is coated on the base material flank 11. A lower limit of a coating thickness 15a of the flank coating 15 may be, for example, 3µm, 5µm, and 7µm. An upper limit of the coating thickness 15a may be, for example, 12µm, 15µm, and 20µm. The coating thickness 15a is within each combination of the illustrated lower and upper limits. The coating thickness 15a is preferably from 5µm to 12µm. The lower limit of the coating thickness 15a is set to the thickness at which the coating functions. The upper limit of the coating thickness 15a is set to reduce coating forming time and production costs.

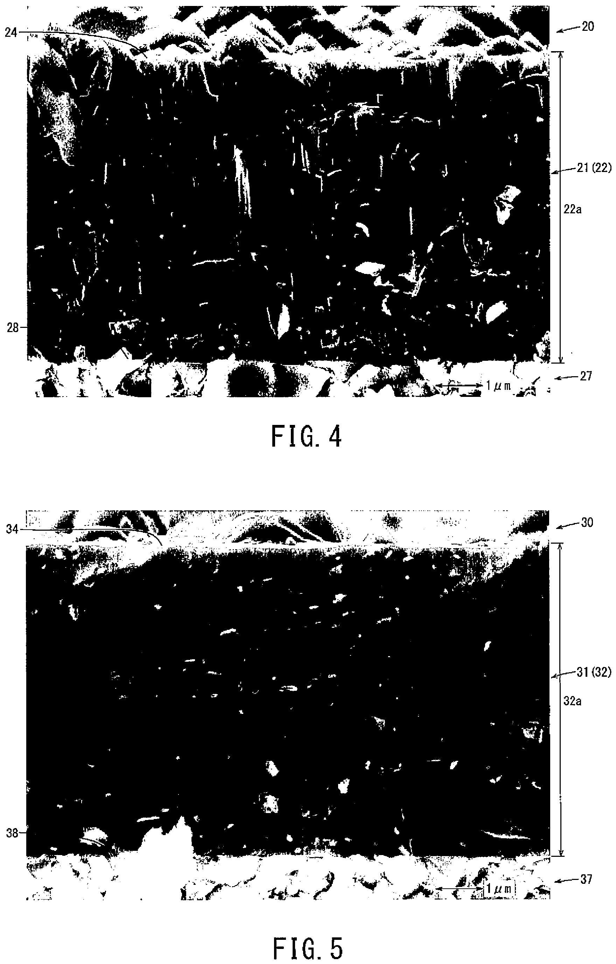

The flank coating 15 shown in FIG. 2 has a columnar structure rising from the base material flank 11. The columnar structure is formed with a plurality of columnar particles standing in parallel along the thickness (coating thickness) direction of the coating. The columnar structure preferably has the same length as the coating thickness 15a. The columnar structure may have a length of, for example, greater than or equal to 50%, 60%, 70%, 80%, or 90% of the coating thickness 15a. The columnar structure may stand toward a direction of 60° to 120° with respect to the base material flank 11. A plurality of adjacent columnar particles preferably stands at the same inclination angle. For example, the particle diameter (thickness) of the particles making the columnar structure with a coating thickness of 15a of 7.5µm is 1µm to 5µm. The length, particle diameter, and inclination angle of the columnar structure were measured from a photograph of a cross-section of the blade 2 observed under an electron microscope (see FIG. 4).

As shown in FIG. 2, chipping and coating cracking from the base material cutting edge 13 to the flank coating 15 expands along the extending direction of the columnar structure. Therefore, chipping and coating cracking expands along the direction indicated by an arrow shown within the flank coating 15 in the figure. In other words, chipping and coating cracking will not expand in a direction that is roughly parallel to the flank 3, for example.

As shown in FIG. 2, the rake face coating 16 has an upper layer removed from the rake face 4 during the manufacturing process of the replaceable blade 1. The rake face 4 is a plane substantially parallel to the base material rake face 12 with a coating thickness (distance) 16a from the base material rake face 12. By finishing the rake face 4, the cutting edge 5 is formed sharply. The coating thickness 16a may be set to 0µm and all of the rake face coating 16 may be removed.

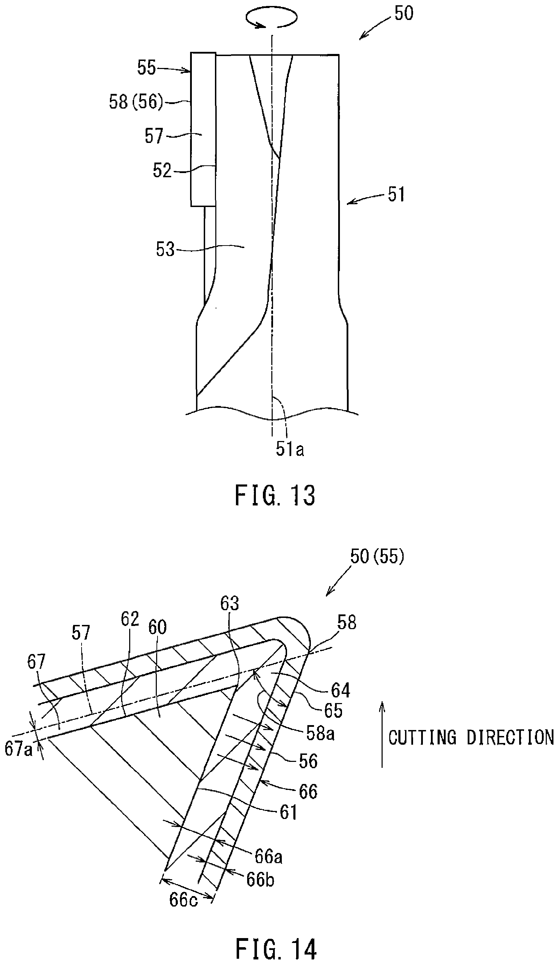

A cutting tool according to the second embodiment of the present disclosure will be described with reference to the drawings. As shown in FIGS. 13 and 14, the cutting tool of the second embodiment may be, for example, a router bit 50 for woodworking. The router bit 50 is cylindrical in shape and is rotated around an axis 51a of the shaft 51 to cut the workpiece. At an end of the shaft 51, a blade 55 is brazed to a recessed tip sheet 52. A cutting chip discharge groove 53 is provided in front of the blade 55 in the direction of rotation to discharge cutting chips generated in the cutting process.

As shown in FIGS. 13 and 14, the blade 55 has a flank 56 and a rake face 57. The flank 56 and the rake face 57 intersect at a cutting edge angle 58a to form a straight cutting edge 58 at the intersection. The cutting edge angle 58a may be an acute angle of, for example, 50° to 60°. The rake face 57 generally faces forward in the direction of rotation of the router bit 50. The flank 56 faces generally outward in the radial direction of the router bit 50. The router bit 50 is rotated with the cutting edge 58 cutting into the workpiece at a predetermined cutting depth. The cutting edge 58 cuts the workpiece at the predetermined cutting depth as the router bit 50 is moved relative to the workpiece in the cutting direction shown in FIG. 14.

As shown in FIG. 14, the flank 56 and the rake face 57 of the router bit 50 are flat, following the base material flank 61 and the base material rake face 62. The base material flank 61 and the base material rake face 62 intersect at a cutting edge angle 58a to form a base material cutting edge 63 at the intersection. The rake face 57 includes a coating 64 covering the base material 60, and the coating 64 is exposed at the rake face 57. The flank 56 has a flank coating 66 that includes the coating 64 and a second coating 65. The second coating 65 covers the coating 64 and the second coating 65 is exposed at the flank 56.

The coating 64 and the second coating 65 shown in FIG. 14 include one or more of chromium nitride, oxynitride, oxide, carbide, carboxide, carbonitride, and carboxynitride. The coating 64 and the second coating 65 may include, for example, chromium nitride (CrN), chromium oxynitride (CrNO), chromium oxide (CrO), chromium carbide (CrC), chromium carboxide (CrCO), chromium carbonitride (CrCN) and chromium carboxynitride (CrCNO). Each of the coating 64 and the second coating 65 has a single layer structure constituted of one or more chromium materials. The coating 64 and the second coating 65 are preferably of different types or have mixing ratios of chromium materials, but the type or the mixing ratio or both of the chromium materials may be the same.

As shown in FIG. 14, in the flank coating 66, the coating 64 covers the base material flank 61 with a coating thickness 66a. In the flank coating 66, the second coating 65 covers the coating 64 with a coating thickness 66b. The ratio of the coating thickness 66a of the coating 64 to the coating thickness 66b of the second coating 65 may be, for example, 1:1 to 3:1, preferably 1.5:1 to 2.5:1. A lower limit of the total coating thickness 66c, which is the sum of the coating thickness 66a of the coating 64 and the coating thickness 66b of the second coating 65, may be for example 3µm, 5µm, or 7µm. An upper limit of the total coating thickness 66c may be, for example, 12µm, 15µm, and 20µm. The total coating thickness 66c is within the range of each combination of the lower and upper limits as illustrated. The total coating thickness 66c may preferably be from 5µm to 12µm.

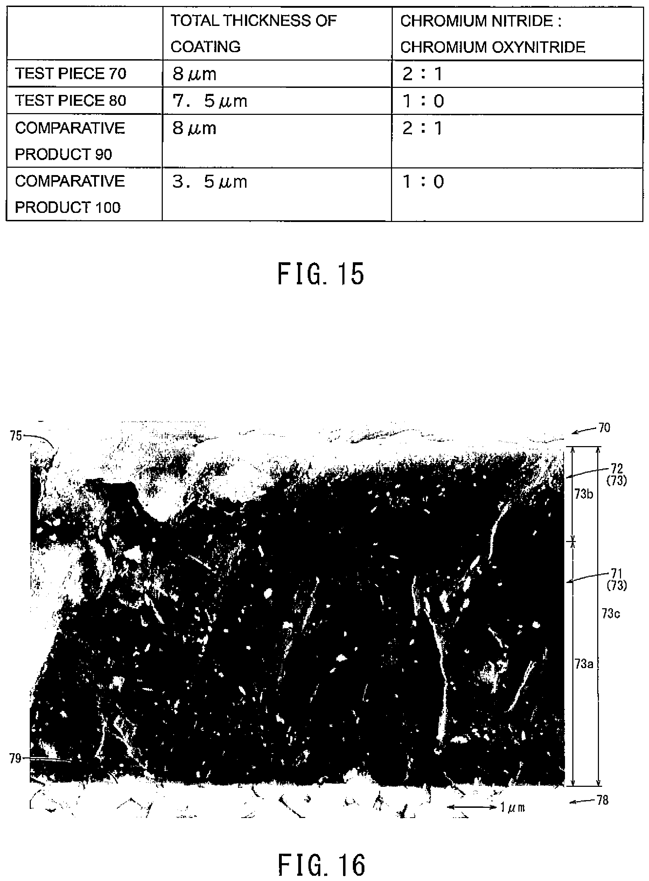

The coating 64 shown in FIG. 14 has a columnar structure rising from the base material flank 61 in the flank coating 66. The columnar structure is formed with a plurality of columnar particles aligned in parallel that is standing on the base material flank 61 in a vertical direction. The columnar structure preferably has the same length as the coating thickness 66a of the coating 64. The columnar structure may have a length, for example, equal to or greater than 50%, 60%, 70%, 80%, or 90% of the coating thickness 66a of the coating 64. The columnar structure may, for example, stand toward a direction of 60° to 120° with respect to the base material flank 61. It is within a range of ±30° to a direction perpendicular direction (90°) to the base material flank 61. A plurality of adjacent columnar particles is preferably raised at the same inclination angle. The particle diameter (thickness) of the particles making the columnar structure may be, for example, 1µm to 3µm with the coating thickness 66a of the coating 64 being 5µm. The length, particle diameter, and inclination angle of the columnar structure were measured by a photograph of a cross section of the blade 55 observed under an electron microscope (see FIG. 16).

The second coating 65 shown in FIG. 14 has a columnar structure rising from the coating 64 in the flank coating 66. Alternatively, the second coating 65 may be a granular structure composed of a plurality of particles that cannot be discerned as a distinct columnar structure in the flank coating 66. The particle diameter of the particles of the second coating 65 may be, for example, 50 to 150% of the particle diameter of the particles making the coating 64.

As shown in FIG. 14, the chipping and coating cracking from the base material cutting edge 63 to the flank coating 66 expand along extending direction of the columnar structure of the coating 64. Therefore, the chipping and coating cracking expand along the direction of the arrow indicated in the coating 64 of the flank coating 66 in the figure.

As shown in FIG. 14, an upper layer of the rake face coating 67 above the rake face 57 is removed. The rake face 57 is a plane substantially parallel to the base material rake face 62 with a coating thickness (distance) 67a from the base material rake face 62. Alternatively, the rake face 57 may be located on the base material rake face 62 (coating thickness 67a is 0µm). Alternatively, the rake face 57 may be located within the coating 64, at the boundary surface between the coating 64 and the second coating 65, or within the second coating 65. The rake face 57 is finished to form a sharp cutting edge 58. The rake face 57 is not parallel to the base material rake face 62, but may be inclined in a direction that reduces the amount of finishing (amount to be removed) and increases the blade angle. This facilitates finishing (polishing). All of the rake face coating 67 may be removed and the base material rake face 62 may be used as the rake face 57. The base material of the rake face 57 wears first so that the cutting edge 58 may be maintained to be sharp by the coating 64 and the second coating 65.

A method of manufacturing a cutting tool covered with a coating includes forming a base material that has a base material flank and a base material rake face (Step 1). The coating material including a chromium-contained material is prepared. If a second coating is provided, additional material including another chromium-contained material is provided if necessary (Step 2). The base material flank and the base material rake face are covered with a coating including a chromium-contained material by PVD treatment (Step 3). When forming a coating with a columnar structure to be coated on the base material flank and the base material rake face, the coating is made to grow in a columnar shape in a rising direction with respect to the base material flank and the base material rake face. In other words, crystals are grown to extend long in a predetermined direction so that their particle diameter is larger than a coat of the conventional PVD coating formation.

The columnar structure is grown until the coating covering the flank reaches a predetermined length (Step 4). If the coating is to be covered with a second coating, after forming the coating on the base material flank and the base material rake face, a second coating is formed on the upper layer of the coating. After the coating is formed, the rake face is ground flat to remove a part or all of the upper layer of the coating covering the rake face (Step 5). This results in a sharp finishing of cutting edges at the intersection of the rake face and flank.

The arc ion plating method may be used as PVD in step 3. Alternatively, a magnetron sputtering method, for example, may be used as PVD. Regarding Step 4, all of CrN, CrNO, CrO, CrC, CrCO, CrCN, and CrCNO may be formed into long columnar structures with large particle diameter by the same PVD process. Example.

Hereinafter, an embodiment according to the present disclosure will be described using specific numbers. As shown in FIG. 3, a test piece 20, a comparative product 30, and a comparative product 40 for the first embodiment were prepared. The test piece 20 for the first embodiment is a replaceable blade 1 of the first embodiment. The comparative products 30 and 40 are replaceable blades with a coating with a conventional coating structure covering on the same cemented carbide base material as the test piece 20. The test piece 20 and comparative products 30 and 40 are covered with a single layer coating formed of a chromium nitride (CrN) material. The coating does not contain chromium oxide (Cr₂O₃).

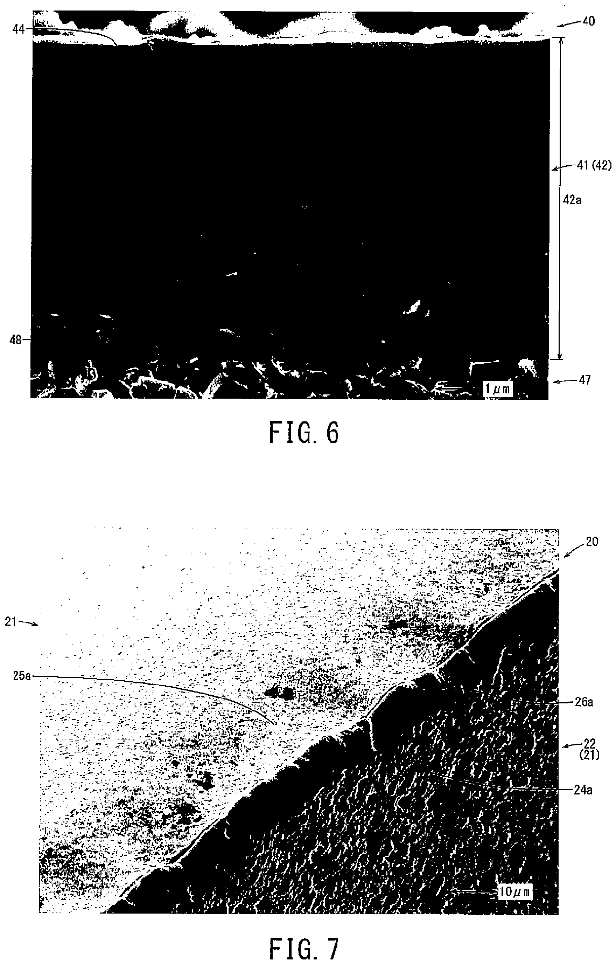

As shown in FIG. 4, the base material 27 of the test piece 20 is covered with a coating 21. The flank coating 22 covering the base material flank 28 is formed with a coating thickness 22a of 7.5µm. The flank coating 22 is a columnar structure rising from the base material flank 28 in a direction substantially orthogonal to the base material flank 28. A tip of the columnar structure is exposed on the flank 24. Entire coating on the rake face 25 is removed by grinding (see FIG. 7).

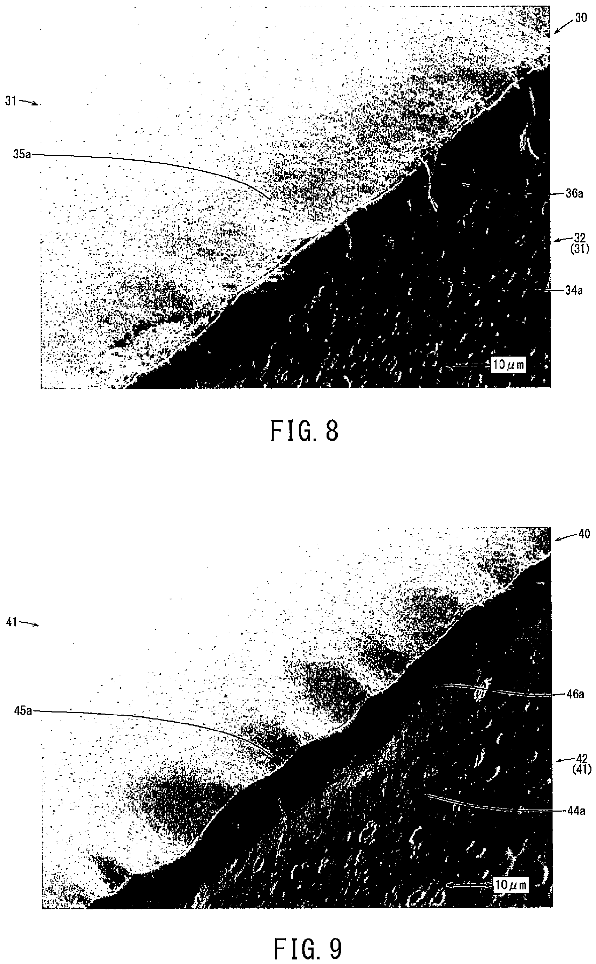

As shown in FIG. 5, the base material 37 of the comparative product 30 is covered with a coating 31. The flank coating 32 to cover the base material flank 38 is formed with a coating thickness 32a of 7.6µm. Although, the flank coating 32 has a columnar structure extending in a direction substantially orthogonal to the base material flank 38, the columnar structure is short as about 10% of the coating thickness 32a. A granular structure with a smaller particle diameter than the columnar structure is formed in gaps between the columnar structure. The flank coating 32 has an intermediate structure with the columnar structure and the granular structure. Tips of both the columnar and granular structures are exposed on the flank 34. All of the coating on the rake face 35 was removed by grinding (see FIG. 8).

As shown in FIG. 6, the base material 47 of the comparative product 40 is covered with a coating 41. The flank coating 42 to cover the base material flank 48 is formed with a coating thickness 42a of 7.8µm. The flank coating 42 is a granular structure having a particle diameter smaller than the particles constituting the flank coating 22 (see FIG. 4) and having no discernible distinct longitudinal direction. A tip of the granular structure is exposed on the flank 44. All of the coating on the rake face 45 was removed by grinding (see FIG. 9).

A cutting test was conducted to cut laminated red pine wood by a cutter (cutting diameter 35 mm) equipped with a replaceable blade 1. The workpiece was cut for 150m under the following cutting condition: a rotational speed of 7714 rpm, a feed rate of a workpiece at 0.643 m/min, a depth of cut of the cutting tool into the workpiece of 9mm in the radial direction, and a depth of cut of the cutting tool in the axial direction of 9mm. The sharpness of the cutting edge 5 after cutting was then evaluated based on the observation results of the condition of the cutting edge 5 after cutting and the measurement results of the change in the cutting edge line before and after cutting. The change in the cutting edge line was evaluated based on an amount of cutting-edge retraction of the rake face 4 and a rounding radius of the cutting edge 5.

As shown in FIG. 7, after the cutting test of the test piece 20, the rake face 25a has formed a crater wear along the cutting edge 26a due to abrasion, and the cutting edge 26a extends linearly. The cutting edge 26a, consisting of the coating 21, is chipped or coating cracked in the columnar direction, and the chipping or coating cracking does not expand in the direction of the flank 24a; therefore, maintaining the coating thickness and the cutting edge shape.

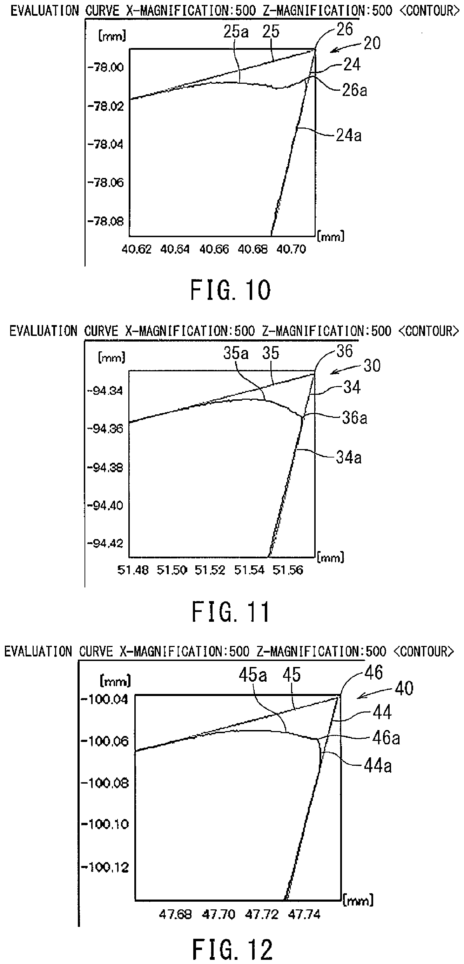

As shown in FIG. 10, after the cutting test of the test piece 20, the amount of cutting-edge retraction on the rake face is approximately 9µm. The cutting edge 26a after the cutting test remains sharp with a very small rounding radius compared to the cutting edge 26 before the cutting test.

As shown in FIG. 8, after the cutting test of the comparative product 30, the rake face 35a and the flank 34a are worn, and the coating thickness of the coating 31 on the cutting edge 36a is not maintained.

As shown in FIG. 11, after the cutting test of the comparative product 30, the amount of cutting-edge retraction on the rake face is approximately 16µm. The cutting edge 36a after the cutting test is rounded with a larger rounding radius than the cutting edge 36 before the cutting test, and the sharp cutting edge of the coating is damaged.

As shown in FIG. 9, after the cutting test of the comparative product 40, the rake face 45a and the flank 44a are worn and the coating thickness of the coating 41 on the cutting edge 46a is not maintained.

As shown in FIG. 12, after the cutting test of the comparative product 40, the amount of cutting-edge retraction of the rake face is approximately 12µm. The cutting edge 46a after the cutting test has a rounded shape with a larger rounding radius than the cutting edge 46 before the cutting test, and the sharp cutting edge of the coating is damaged.

As shown in FIGS. 7 to 12, it was found that the amount of cutting-edge retraction on the rake face of the test piece 20 with a columnar structure is small even after 150m of cutting, and the sharp cutting edge was maintained. Cutting edges of a comparative product 30 with an intermediate structure are chipped and rounded after cutting 150m and its sharp cutting edges are damaged. Comparative product 40 with a granular structure, showed more chipping of the cutting edges than those of the comparative product 30, and its sharp cutting edges are more damaged.

A cutting test was conducted to cut laminated red pine wood by a router bit 50 (cutting diameter 12mm). The workpiece was cut for 150m under the following cutting condition: the rotational speed of 18000 rpm, the feed rate of the workpiece at 0.643 m/min, the depth of cut of the cutting tool into the workpiece of 3mm in the radial direction, and the depth of cut of the cutting tool in the axial direction of 10mm. For a test piece 70, a 400m cutting test, which is longer than the normal tool life, was also conducted. The sharpness of the cutting edge 58 after cutting was evaluated based on the observation results of the condition of the cutting edge 58 after cutting, and the measurement results of the change in the cutting edge line before and after cutting. The change in the cutting edge line was evaluated based on the amount of cutting-edge retraction of the rake face and the rounding radius of the cutting edge 58.

As shown in FIG. 15, test pieces 70, 80, and comparative products 90, 100 for the second example were prepared. The test piece 70 is the router bit 50 of the second embodiment (see FIG. 13). The blade of test piece 80 corresponds to the blade 2 of the first embodiment (see FIG. 2). The comparative products 90, 100 are router bits in which the same base material as the test piece 70 is covered with a coating that has a conventional coating structure. The test piece 70 and the comparative product 90 are covered with a coating made of chromium nitride (CrN) material and a second coating made of chromium oxide (Cr₂O₃) material. Test piece 80 and comparative product 100 are covered only with a coating made of chromium nitride (CrN) and not with a second coating made of chromium oxide (Cr₂O₃). All of the coating on the rake faces of the test pieces 70, 80 as well as comparative products 90, 100 were removed by grinding.

As shown in FIG. 16, the base material 78 of the test piece 70 is covered with a coating 71 and a second coating 72. The coating 71 of the flank coating 73, which covers the base material flank 79, is formed with a coating thickness 73a of 5.3µm. The second coating 72, which overs the coating 71 of the flank coating 73, is formed with a coating thickness 73b of 2.7µm. In other words, the total thickness 73c of the flank coating 73 is 8µm, and the ratio of the coating thickness 73a of the coating 71 to the coating thickness 73b of the second coating 72 is approximately 2:1.

As shown in FIG. 16, in the flank coating 73, the coating 71 is a columnar structure rising from the base material flank 79 in a direction substantially orthogonal to the base material flank 79. The columnar structure extends in the thickness direction with the same length as the coating thickness 73a. The second coating 72 has an intermediate structure that has a columnar structure with length in the thickness direction is shorter than the particles of the coating 71, and a granular structure with a particle diameter is smaller than the particles of the coating 71. The tip of the granular structure of the second coating 72 is exposed on the flank 75.

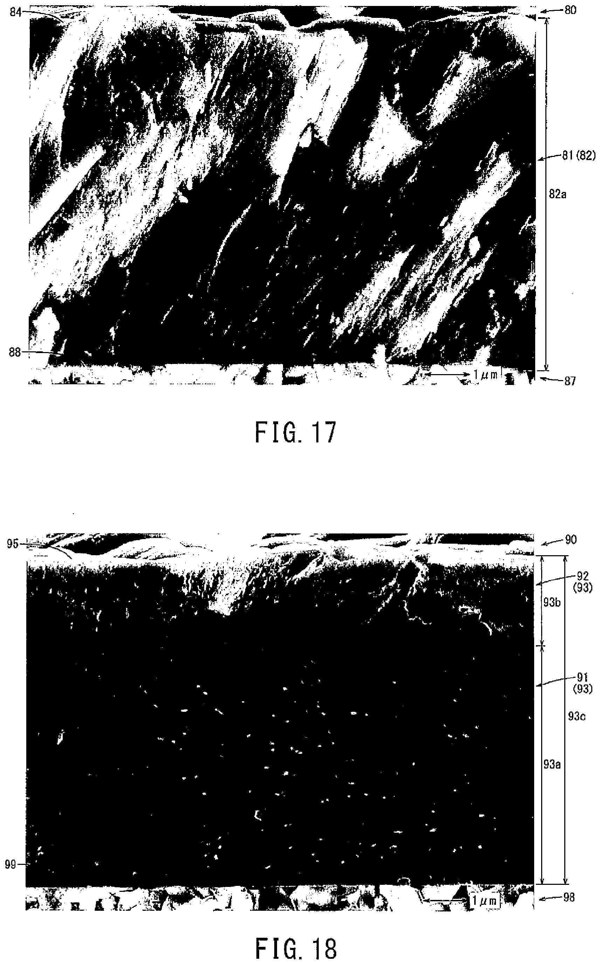

As shown in FIG. 17, coating 81 covers the base material 87 of the test piece 80. The flank coating 82 covering the base material flank 88 has a coating thickness 82a of 7.5µm. The flank coating 82 is a columnar structure extending in a direction inclined at approximately 60° to the base material flank 88. The columnar particles extend in the thickness direction with the same length as the coating thickness 82a. The tip of the columnar structure is exposed on the flank 84.

As shown in FIG. 18, the base material 98 of the compared product 90 is covered with a coating 91 and a second coating 92. The coating 91 of the flank coating 93 covering the base material flank 99 has a coating thickness 93a of 5.3µm. The second coating 92 covering the coating 91 of the flank coating 93 has a coating thickness 93b of 2.7µm. In other words, the total thickness 93c of the flank coating 93 is 8µm, and the ratio of the coating thickness 93a of the coating 91 to the coating thickness 93b of the second coating 92 is approximately 2:1.

As shown in FIG. 18, in the flank coating 93, the coating 91 is a granular structure having no discernible distinct longitudinal direction. The second coating 92 has a granular structure with a larger particle diameter than the particles of the coating 91. The tip of the granular structure of the second coating 92 is exposed on the flank 95.

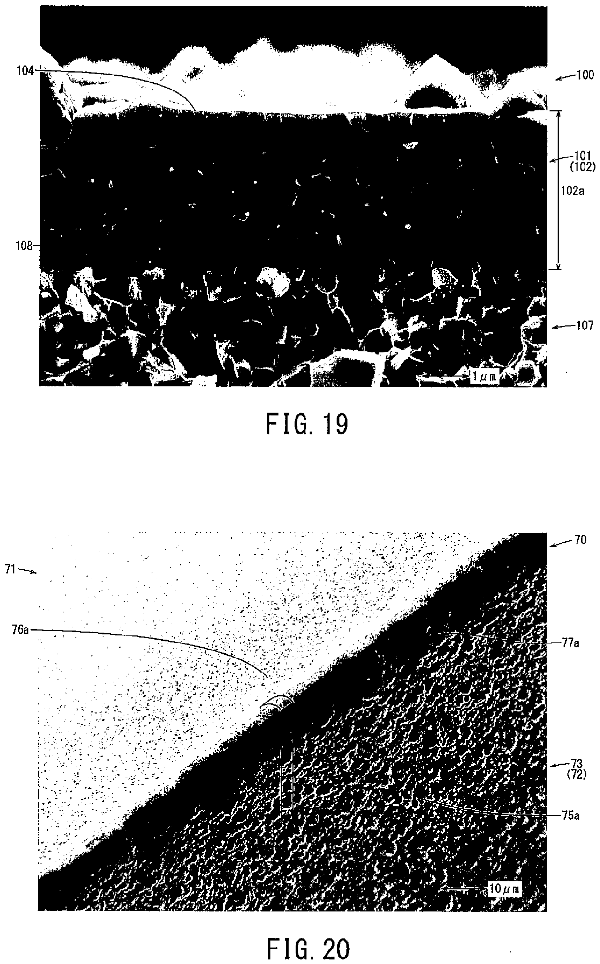

As shown in FIG. 19, a coating 101 covers the base material 107 of the comparative product 100. The flank coating 102 covering the base material flank 108 has a coating thickness 102a of 3.5µm. The particles comprising the flank coating 102 are granular with a smaller particle diameter than the columnar particles of the flank coating 82 (see FIG. 17) and having no discernible distinct longitudinal direction. The tips of the granular particles are exposed on the flank 104.

As shown in FIG. 20, after a 150m cutting test of the test piece 70, the rake face 76a has formed a crater wear along the cutting edge 77a due to abrasion, and the cutting edge 77a clearly extends linearly. When chipping or coating cracking occurs, it occurs in the direction of the columnar shape of the flank coating 73 shown schematically in the figure, and the columnar particles fall off in order from the tip while maintaining the sharpness of the cutting edge 77a. Therefore, chipping and coating cracking do not expand in the direction of the flank 75a, therefore maintaining the coating thickness before and after chipping and coating cracking as well as the cutting edge shape.

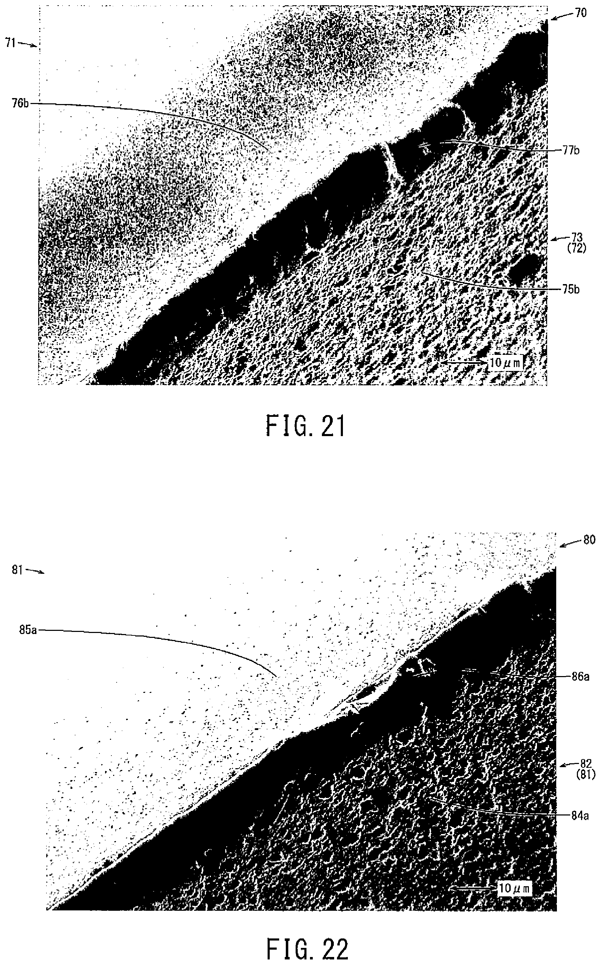

As shown in FIG. 21, after a 400m cutting test of the test piece 70, the rake face 76b has formed a crater wear along the cutting edge 77b due to abrasion, and the cutting edge 77b extends linearly. No chipping or coating cracking expands in the direction of the flank 75b, therefore maintaining the coating thickness as well as the cutting edge shape.

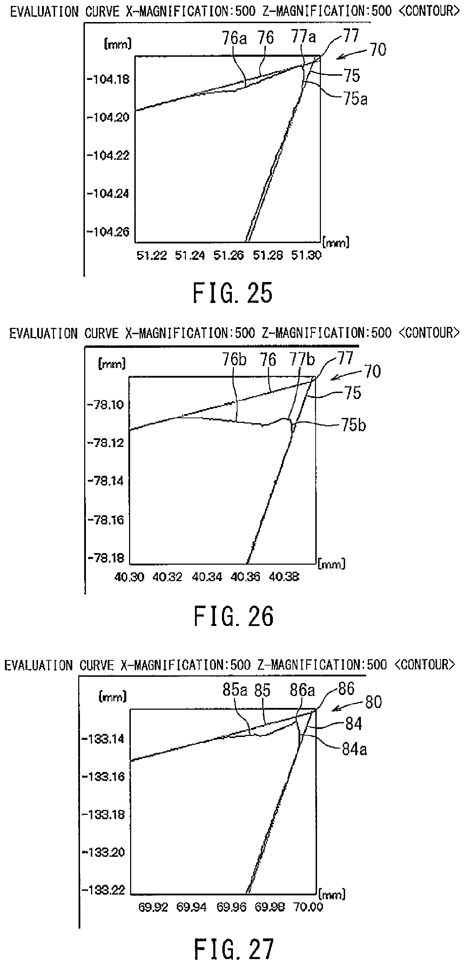

As shown in FIG. 25, after the 150m cutting test of the test piece 70, the amount of cutting-edge retraction of the rake faces (76, 76a) is approximately 6µm. The cutting edge 77a after the cutting test remains sharp with a very small rounding radius compared to the cutting edge 77 before the cutting test.

As shown in FIG. 26, after the 400m cutting test of the test piece 70, the amount of cutting-edge retraction of the rake faces (76, 76b) is approximately 15µm. The cutting edge 77b after the cutting test has a slightly rounded shape with an enlarged rounding radius compared to the cutting edge 77 before the cutting test.

As shown in FIG. 22, after the 150m cutting test of the test piece 80, the rake face 85a has formed a depression along the cutting edge 86a due to abrasion, and the cutting edge 86a maintains a generally straight extension. No chipping and coating cracking expands in the direction of the flank 84a, therefore, maintaining the coating thickness and the cutting edge shape.

As shown in FIG. 27, after the 150m cutting test of the test piece 80, the amount of cutting-edge retraction of the rake faces (85, 85a) is approximately 8µm. The cutting edge 86a after the cutting test remains sharp compared to the cutting edge 86 before the cutting test.

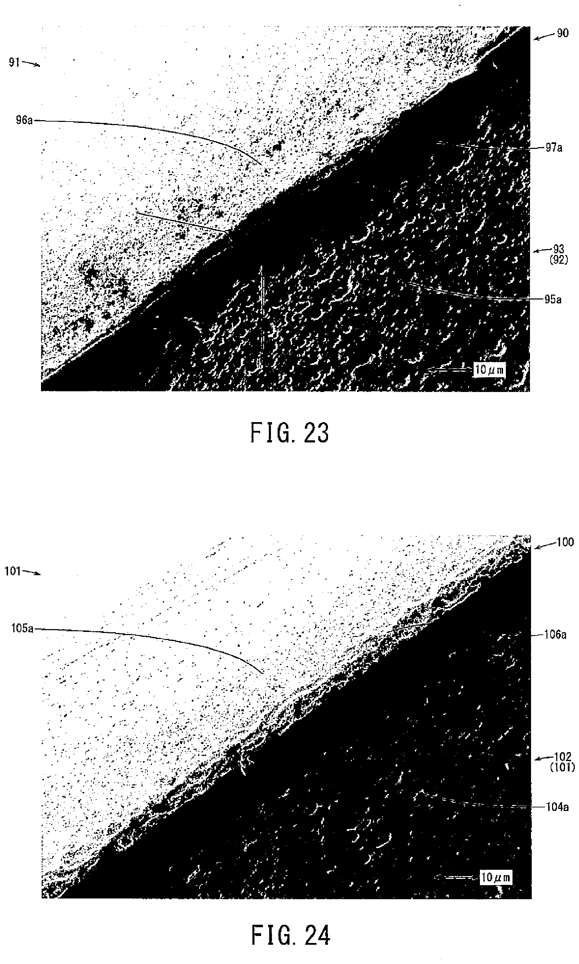

As shown in FIG. 23, after the 150m cutting test of the comparative product 90, the rake face 96a has formed a depression along the cutting edge 97a due to abrasion. However, the coating on the flank 95a is cracked with the carbide base material of the cutting edge 97a at the apex. Compared to the cutting edge 77a (see FIG. 20) and the cutting edge 86a (see FIG. 22), the cutting edge 97a has a rounded shape with the corners on the flank 95a side removed. In other words, the sharp cutting edges of the coating are not maintained. When chipping or coating cracking occurs, the granular particles located on the cutting edge 97a fall off, as schematically shown in the figure. As a result, the chipping or coating cracking expands in the cutting direction, and the entire cutting edge 97a becomes uniformly rounded.

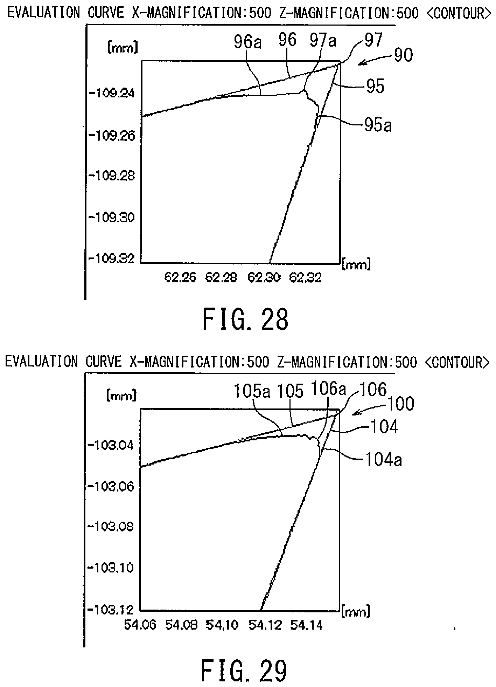

As shown in FIG. 28, after the 150m cutting test of the comparative product 90, the amount of cutting-edge retraction of the rake face (96, 96a) is approximately 15µm. The cutting edge 97a after the cutting test has a rounded shape with a larger rounding radius than the cutting edge 97 before the cutting test. In other words, the sharp cutting edge of the coating is damaged.

As shown in FIG. 24, the rake face 105a and the flank 104a are worn after a 150m cutting test of the comparative product 100. The coating cracks and the coating as a cutting edge 106a is missing.

As shown in FIG. 29, after the 150m cutting test of the comparative product 100, the amount of cutting-edge retraction of the rake face (105, 105a) is approximately 12µ. The cutting edge 106a is worn after the cutting test. The coating is cracked and a coating as the cutting edge 106a is missing. The sharp cutting edge of the coating is damaged compared to the cutting edge 106 before the cutting test.

As shown in FIGS. 20 to 29, it was found that the amount of cutting-edge retraction on the rake face of the test pieces 70 and 80 with the columnar structure is small even after the 150m of cutting, and the sharp cutting edge was maintained. It was found that the amount of cutting-edge retraction on the rake face of the test piece 70 having a columnar coating covered with an oxide coating is smaller than that of the test piece 80 without an oxide coating. Cutting edges of the comparative product 90 having a coating with a granular structure covered with an oxide coating are chipped and rounded after cutting 150m and its sharp cutting edges are damaged. Cutting edges with sharper coating than the comparative product 90 are damaged due to coating cracking in the flank direction and abrasion. It was found that the amount of cutting-edge retraction of the test piece 70 on the rake face after the 150m cutting was less than half that of the comparative product 100, and that the sharp cutting edge of the coating was relatively maintained after the 400m cutting.

The various examples described above in detail with reference to the accompanying drawings are representative examples of the invention and are not intended to limit the invention. The detailed description is intended to teach those skilled in the art to make, use and/or practice the various aspects of the present teachings and is not intended to limit the scope of the invention. Furthermore, each of the additional features and teachings described above may be applied and/or used separately or in conjunction with other features and teachings to provide improved cutting tools and/or methods of making and using the same.

## Claims

1. A cutting tool for cutting workpieces made of nonferrous metals, nonferrous metal alloys, wood, woody materials, or resins comprising:
a coating configured to cover a base material, wherein the coating is provided on a flank of a cutting edge at an intersection of a rake face and the flank, and wherein the coating has a columnar structure rising from the base material,
wherein base material making the coating includes one or more of chromium nitride, oxynitride, oxide, carbide, carboxide, carbonitride and carboxynitride.

2. The cutting tool according to claim 1 comprising a second coating for covering the coating, wherein the second coating includes one or more of chromium nitride, oxynitride, oxide, carbide, carboxide, carbonitride, and carboxynitride.

3. A method of manufacturing a cutting tool for cutting workpieces made of nonferrous metals, nonferrous metal alloys, wood, woody materials, or resins comprising:
forming a coating on a base material including a columnar structure rising on a surface of the base material,
wherein base material making the coating includes one or more of chromium nitride, oxynitride, oxide, carbide, carboxide, carbonitride, and carboxynitride;
forming the coating over a rake face and a flank; and
removing some or entire coating on the rake face to obtain sharp cutting edge where the rake face intersects with the flank.
